# EUROPEAN PATENT SPECIFICATION

(11) **EP 1 556 395 B1**
(45) Date of publication and mention of the grant of the patent: **12.09.2018**
(21) Application number: 03810820.5
(22) Date of filing: 30.10.2003
(51) Int. Cl.: C07F 17/02, C23C 16/00

(54) **METHODS FOR MAKING METALLOCENE COMPOUNDS**
VERFAHREN ZUR HERSTELLUNG VON METALLOCENVERBINDUNGEN
PROCEDES DE PRODUCTION DE COMPOSES METALLOCENE

(30) Priority: 31.10.2002 US 422946 P; 31.10.2002 US 422947 P; 14.11.2002 US 426284 P; 18.11.2002 US 427461 P; 07.02.2003 US 446320 P; 18.04.2003 US 453718 P; 18.04.2003 US 453719 P; 18.04.2003 US 453717 P; 16.10.2003 US 685777; 16.10.2003 US 685785; 16.10.2003 US 686254
(43) Date of publication of application: 27.07.2005
(73) Proprietor: PRAXAIR TECHNOLOGY, INC., Danbury, CT 06810-5113 (US)
(72) Inventor: THOMPSON, David, M., East Amherst, NY 10451 (US); HOOVER, Cynthia, A., Grand Island, NY 14072 (US)
(74) Representative: BRP Renaud & Partner mbB Rechtsanwälte Patentanwälte Steuerberater
(86) International application number: PCT/US2003/034498
(87) International publication number: WO 2004/042354

(56) References cited:
- US-A- 3 035 978
- US-A- 3 109 852
- US-A- 3 259 642
- US-A- 3 294 685
- US-A- 3 535 356
- US-A1- 2002 161 253
- DATABASE CA [Online] CHEMICAL ABSTRACTS SERVICE, COLUMBUS, OHIO, US; WILCZEWSKI, TADEUSZ: "Ruthenocene" XP002463815 retrieved from STN Database accession no. 103:123714 & PL 124 360 B1 (POLITECHNIKA GDANSKA, POL.) 31 January 1983 (1983-01-31)
- DATABASE CA [Online] CHEMICAL ABSTRACTS SERVICE, COLUMBUS, OHIO, US; BRUCE, MICHAEL I. ET AL: "Cyclopentadienylruthenium and -osmium chemistry. IV. Convenient high-yield synthesis of some cyclopentadienylruthenium or -osmium tertiary phosphine halide complexes" XP002463816 retrieved from STN Database accession no. 87:184657 & AUSTRALIAN JOURNAL OF CHEMISTRY , 30(7), 1601-4 CODEN: AJCHAS; ISSN: 0004-9425, 1977,
- STEPHENSON, T.A. ET AL.: "New compelxes of ruthenium(II) and (III) with triphenylphosphine, triphenylarsine, tripchlorostannate, pyridine and other ligands", J. INORG. NUCL. CHEM ., vol. 28, 1966, pages 945-956,
- KLASS, K. ET AL.: "Formation and structural properties of 1,1',2,2'-tetra(tert-butyl-carbamoyl)-ferr ocene and -ruthenocene", J. CHEM. SOC., DALTON TRANS., 1999, pages 4457-4461,
- S. CHAO. ET AL.: "A new ferrocenophane surface derivatizing reagent for the preparation of nearly reversible electrodes for horse heart ferri/ferrocytochrome c: 2,3,4,5-tetrfamethyl-1-((dichlorosilyl)met hyl)[2]-ferrocenophane", JOURNAL OF THE AMERICAN CHEMICAL SOCIETY, vol. 105, 1983, pages 181-188,

## Description

### BACKGROUND OF THE INVENTION

Chemical vapor deposition (CVD) methods are employed to form films of material onto substrates such as wafers or other surfaces during the manufacture or processing of semiconductors. In CVD, a CVD precursor, also known as a CVD chemical compound, is decomposed thermally, chemically, photochemically or by plasma activation, to form a thin film having a desired composition. For instance, a vapor phase CVD precursor can be contacted with a substrate that is heated to a temperature higher than the decomposition temperature of the precursor, to form a metal or metal oxide film on the substrate.

Preferably, CVD precursors are volatile, heat decomposable and capable of producing uniform films under suitable CVD conditions. In producing thin films by CVD processes, precursors that are liquid at room temperature, rather than solid, often are preferred.

Thin films that include ruthenium (Ru) or ruthenium oxide (RuO₂), for instance, have good electrical conductivity, high work function, are chemically and thermally stable, resistant to inter-layer chemical diffusion and are compatible with many dielectric substrate materials. Ru and RuO₂ films, for instance, have been investigated as film electrode material for semiconductor devices such as DRAM (Dynamic Random Access Memory) devices.

Bis(*pentahapto*cyclopentadienyl)ruthenium (ruthenocene) and the symmetrical, diethyl-substituted ruthenocene (1,1'-diethylruthenocene) have been investigated as possible precursors for forming ruthenium-based thin films by CVD techniques. Both have relatively low vapor pressure (less than 10 Torr at 100°C). At room temperature, ruthenocene is a solid and 1,1'-diethylruthenocene is a liquid.

To date, ruthenocene or symmetrically substituted 1,1'-diethylruthenocene have been prepared by several synthetic routes.

In Polish patent PL 124360 a process for preparing ruthenocene starting from a ruthenium-cyclopentadienyl-triphenylphosphine compound is disclosed. Bruce et al have disclosed a process for preparing a ruthenium-cyclopentadienyl-phosphine compound in Aust. J. Chem., 1977, 30, pages 1601-1614.

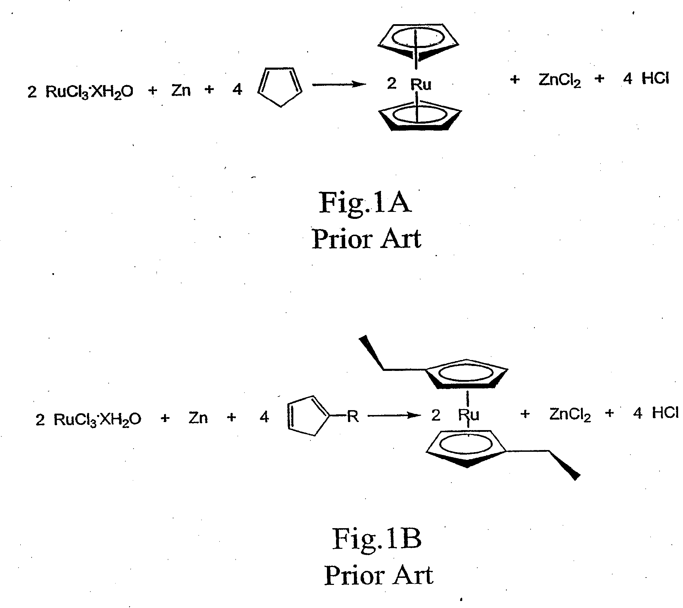

One existing method for forming ruthenocene includes the reaction of RuCl₃·XH₂O with cyclopentadiene, in the presence of Zn, to produce ruthenocene, ZnCl₂ and HCl, as shown in Fig. 1A. A similar approach, using ethyl-substituted cyclopentadiene, has been employed to produce 1,1'-diethylruthenocene, as shown in Fig. 1B. Generally, yields obtained by this method are about 70%.

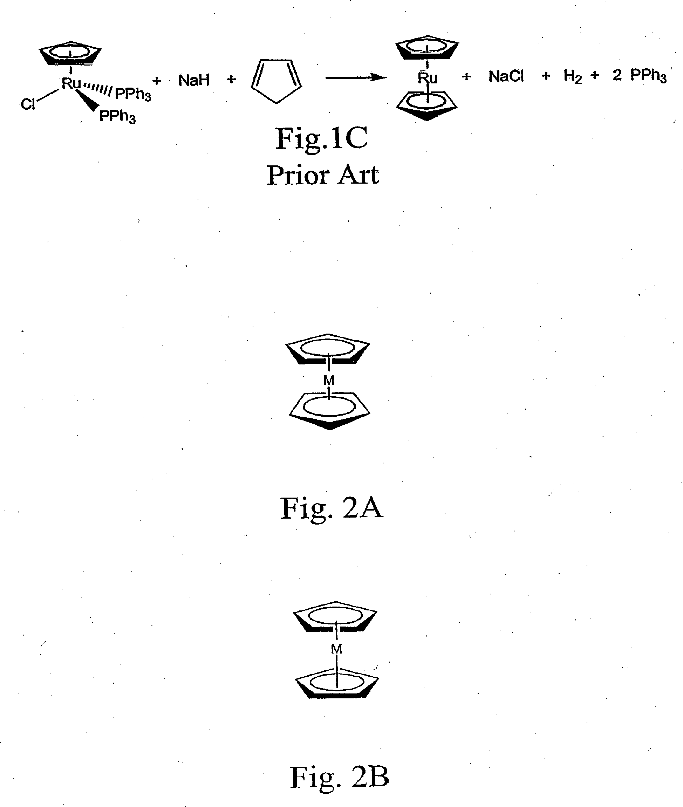

As shown in Fig. 1C, unsubstituted ruthenocene also has been prepared by the reaction of cyclopentadiene, chloro(cyclopentadienyl)bis(triphenylphosphine) ruthenium(II) and sodium hydride (NaH) in benzene. Chloro(cyclopentadienyl)bis(triphenylphosphine) ruthenium(II) precursor has been synthesized by reacting ruthenium trichloride and triphenylphosphine in ethanol.

Another method that has been investigated for the synthesis of ruthenocene includes the transmetallation reactions of a bis(alkylcyclopentadienyl) iron compound with RuCl₃·XH₂O and results in the formation of low yield 1,1'-dialkylruthenocene, iron trichloride (FeCl₃) and difficult to separate iron species.

Monosubstituted ruthenocenes, e.g., 1-ethylruthenocene, are formed as an impurity during the synthesis of 1,1'-diethylruthenocene. Tert-butyl(cyclopentadienyl)(cyclopentadienyl)ruthenium also has been prepared by reacting a heated mixture of bis (cyclopentadienyl)ruthenium, aluminum chloride and polyphosphoric acid, with tert-butyl alcohol, followed by distillation.

Generally, synthetic methods described above often are associated with low yields, competing dimerization reactions, require complex product separations, and/or special handling techniques. NaH, for instance, reacts violently with H₂O and also reacts with air.

Furthermore, synthetic approaches shown in Figs. 1A and 1B include a one step addition of both cycolpentadienyl rings and thus are suitable for preparing unsubstituted ruthenocene or the symmetrically substituted 1,1'-diethylruthenocene, but not asymmetric, di-substituted ruthenocenes, such as 1-D₁,1'-D₁'-ruthenocenes, where D₁ and D₁' are different alkyl groups.

In developing methods for forming thin films by CVD methods, a need continues to exist for methods of preparing precursors that preferably are liquid at room temperature, have relatively high vapor pressure and that can form uniform films. A need also continues to exist for versatile methods of preparing ruthenocenes and other Group 8 (VIII) metallocenes. In particular, a need exists for methods for preparing di- or multi-substituted asymmetric Group 8 (VIII) metallocenes.

### SUMMARY OF THE INVENTION

The invention generally is directed to a method for producing Group 8 (VIII) metallocene compounds. In particular, the present invention is a method for producing a Group 8 (VIII) metallocene compound as it is defined in claim 1. The compounds generally have a sandwich-type structure similar to that of ferrocene and are represented by the general formula CpMCp', where M is selected from the group consisting of ruthenium (Ru), osmium (Os) and iron (Fe); Cp is different from Cp', and Cp and Cp' are η^{m}-coordinated cyclic moieties, where m indicates the number of carbon atoms in the cyclic moieties that are believed to be bonded to the metal atom. In specific examples, Cp and Cp' are independently selected to be cyclopentadienyl or indenyl.

In preferred embodiments of the invention, the method includes using a substituted or unsubstituted cyclopentadienyl, indenyl or another η^{m}-coordinated cyclic anion, such as present, in combination with a counter-ion, in salt compounds, e.g., in cyclopentadienide salts. Suitable counterions include lithium (Li), sodium (Na), potassium (K), magnesium (Mg), calcium (Ca), thallium (Tl) cations or trimethylsilyl (TMS). Specific examples of cyclopentadienide salts that can be employed include lithium cyclopentadienide, sodium cyclopentadienide, potassium cyclopentadienide and others.

In one embodiment, the method includes adding the two η^{m}-coordinated cyclic moieties, e.g., cyclopentadienyl or indenyl moieties, sequentially or step-wise. Thus in one example, the invention is directed to a method for producing a Group 8 (VIII) metallocene and includes the steps of reacting a metal salt compound, a Cp compound, e.g., a first cyclopentadienyl compound, and a ligand (L) compound to form an intermediate compound and reacting the intermediate compound with a Cp' compound, e.g., a second cyclopentadienyl compound, to produce the metallocene.

Preferably, Cp is provided as HCp or a substituted HCp and Cp' is provided as a susbstituted or unsubstituted Cp' anion, as described above. L is a phosphine or a phosphite triester.

In a preferred embodiment, at least one H atom in the Cp moiety is replaced by a substituent group D₁. In another preferred embodiment, at least one H atom in the Cp' moiety is replaced by a substituent group D₁'. In yet other embodiments, either or both Cp or Cp' includes at least one additional substituent group, Dₓ or Dₓ'.

D₁ and D₁' can be the same or different. D₁, D₁', Dₓ or Dₓ' groups can be, for example:
A;
Cₐ₁H_{b1}A_{c1};
Cₐ₂H_{b2}A_{c2}(C=O)Cₐ₁H_{b1}A_{c1};
Cₐ₂H_{b2}A_{c2}OCₐ₁H_{b1}A_{c1};
Cₐ₂H_{b2}A_{c2}(C=O)OCₐ₁H_{b1}A_{c1}; and
Cₐ₂H_{b2}A_{c2}O(C=O)Cₐ₁H_{b1}A_{c1};
where
A is a halogen atom, e.g., fluorine (F), chlorine (Cl), bromine (Br) or iodine (I) or a nitro group (NO₂);
a1 is an integer from 1 to 8;
b1 is an integer from 0 to 2(a1)+1 - c1
c1 is an integer from 0 to 2(a1)+1 - b1;
b1 + c1 is at least 1;
a2 is an integer from 0 to 8;
b2 is an integer from 0 to 2(a2) + 1 - c2;
c2 is an integer from 0 to 2(a2) + 1 - b2.

In another embodiment, a metallocene, e.g., ruthenocene, or a symmetrically substituted metallocene (D₁=D₁') is produced by a method that includes the step of reacting an intermediate compound with a Cp' component, such as an anion in a cyclopentadienide salt, as described above. The intermediate compound can be formed by reacting a metal salt compound with a ligand (L).

The methods described above can be conducted with indenyl, and other cyclic moieties capable of forming ηⁿ coordinated compounds, components to form metallocene-like compounds.

The invention has several advantages. For example, the method of the invention is useful in generating CVD precursors that have varied chemical structures and physical properties. The method can be employed to produce ruthenocenes and other Group 8 (VIII) metallocenes, such as, for instance, bis(*pentahapto*cyclopentadienyl)osmium compounds. The method of the invention can produce unsubstituted, mono-substituted, symmetric and asymmetric di-substituted metallocenes as well as symmetric or asymmetric multi-substituted metallocenes. The method can be employed to form metallocene compounds not previously reported. The method results in relatively high product yields and eliminates the need for using sodium hydride and the safety considerations related to its handling. The method is particularly well-suited for scale-up production since it can be conducted using the same equipment, some of the same reagents and process parameters that can easily be adapted to manufacture a wide range of products. In solution, disubstituted asymmetric metallocenes synthesized by the method of the invention do not appear to participate in ring exchange, thus facilitating final purification steps.

### BRIEF DESCRIPTION OF THE DRAWINGS

Fig. 1A depicts a prior art synthetic route for forming unsubstituted ruthenocene.
Fig. 1B depicts a prior art synthetic route for forming 1,1=-diethylruthenocene.
Fig. 1C depicts another prior art method that has been used to form unsubstituted ruthenocene.
Fig. 2A shows the structural formula of a metallocene in a staggered conformation.
Fig. 2B shows the structural formula of a metallocene in an eclipsed conformation.
Fig. 3 shows the structural formula of a disubstituted metallocene.
Fig. 4 shows a generalized structural formula of a metallocene.
Fig. 5 shows illustrative ruthenocene compounds that can be formed by the method of the invention.
Fig. 6 shows one embodiment of a synthetic method for forming a metallocene compound.
Fig. 7 shows one embodiment of the method of the invention for forming 1,1=-diethylruthenocene.
Fig. 8 shows an embodiment of the method of the invention for forming 1-methyl,1'-ethylruthenocene.
Fig. 9 shows another embodiment of the method of the invention for forming 1,1'-diethylruthenocene.

### DETAILED DESCRIPTION OF THE INVENTION

The foregoing and other objects, features and advantages of the invention will be apparent from the following more particular description of preferred embodiments of the invention, as illustrated in the accompanying drawings in which like reference characters refer to the same parts throughout the different views. The drawings are not necessarily to scale, emphasis instead being placed upon illustrating the principles of the invention.

A description of preferred embodiments of the invention follows.

The invention is related to a method for producing metallocenes. As used herein, the term "metallocene" refers to an organometallic coordination compound having a sandwich-type structure similar to that of ferrocene, in which a transition metal is believed to be n-bonded (electrons are moving in orbitals extending above and below the ring) to η^{m}-coordinated cyclic, generally aromatic moiteties, Cp and Cp', where n indicates the number of carbon atoms in the cyclic moiety that are bonded to the transition metal. If all carbon atoms in the cyclopentadienyl ring participate in bonding to the transition metal, these moieties are described as η⁵-coordinated. Thus, a complete description of ferrocene would be (η⁵-C₅H₅)₂Fe. Cp and Cp' are independently selected to be unsubstituted or substituted and can be the same or different from one another.

In preferred embodiments, both Cp and Cp' are independently selected to be cyclopentadienyl or indenyl moieties. As known in the art, indenyl include a phenyl ring fused to a cyclopentadienyl ring.

Other examples of Cp and/or Cp' include cyclo-olefin e.g., cyclohexadienyl, cycloheptadienyl, cyclooctadienyl rings, heterocyclic rings, aromatic rings, such as substituted or unsubstituted benzenyl, and others, as known in the art. As used herein, η^{m}-coordinated moieties Cp or Cp' that are other than cyclopentadienyl are referred to as "cyclopentadienyl-like." Additional counterion groups may be present in such compounds to balance electrical charges and form neutral molecules, as known in the art.

Shown in Fig 2A is a staggered conformation of a metallocene, where M is a Group 8 (VIII) metal, e.g., ruthenium, osmium or iron. Metallocenes also can have an eclipsed conformation, as shown in Fig. 2B. As used herein, molecular formulae are not intended to depict a particular metallocene conformation.

In preferred embodiments, the method of the invention employs a cyclopentadienyl or indenyl, anion, such as generally found in the presence of a counterion in cyclopentadienide or cyclopentadienide-like salts. Examples of suitable counterions include Na, Li, K, Mg, Ca, Tl cations or TMS. Specific examples of cyclopentadienide or cyclopentadienide-like salts include but are not limited to LiCp', KCp' or NaCp'.

In one embodiment, the method of the invention includes the steps of combining a metal salt compound, a ligand (L) compound and a first Cp compound, for instance a cyclopentadiene or indene (HCp), to form an intermediate compound; and reacting the intermediate compound with a second Cp' compound, e.g., including a cyclopentadienyl, indenyl or another Cp' anion, such as described above.

The metal salt can be a metal (III) salt, such as, for example, a metal halide (e.g., chloride, bromide, iodide, fluoride), a metal nitrate. M is a Group 8 (VIII) metal, selected from Ru, Os or Fe. The metal salt is abbreviated as MXₙ. As used herein, the abbreviation MXₙ is an anhydrous or a hydrated metal halide or metal nitrate.

Ligand (L) generally is a phosphine and triphenylphosphine (PPh₃) is employed in one example. Tricyclohexylphosphine and other phosphines of the general formula PR₃, as well as phosphite triesters, P(OR)₃, where R is phenyl, cyclohexyl, alkyl or branched alkyl, e.g., t-butyl, group, also can be employed.

Preferably, the Cp compound is HCp, e.g., cyclopentadiene, indene, and can be unsubstituted or substituted. The Cp compound also can be provided as a salt including a cyclopentadienyl or indenyl anion. Suitable cations that can be used with the anion, include, but are not limited to, TMS, Na, Li, K, Mg, Ca and Tl. Specific examples of salts include KCp, NaCp or LiCp.

In one embodiment of the invention, at least one hydrogen (H) atom in the Cp moiety is replaced by a substitutent group D₁. Examples of D₁ groups include:
A;
Cₐ₁H_{b1}A_{c1};
Cₐ₂H_{b2}A_{c2}(C=O)Cₐ₁H_{b1}A_{c1};
Cₐ₂H_{b2}A_{c2}OCₐ₁H_{b1}A_{c1};
Cₐ₂H_{b2}A_{c2}(C=O)OCₐ₁H_{b1}A_{c1}; and
Cₐ₂H_{b1}A_{c2}O(C=O)Cₐ₁H_{b1}A_{c1};
where
A is F, Cl, Br, I or NO₂;
a1 is an integer from 1 to 8;
b1 is an integer from 0 to 2(a1)+1 - c1;
c1 is an integer from 0 to 2(a1)+1 - b1;
b1 + c1 is at least 1;
a2 is an integer from 0 to 8;
b2 is an integer from 0 to 2(a2) + 1 - c2;
c2 is an integer from 0 to 2(a2) + 1 - b2.

As used herein, integer ranges are inclusive. Straight as well as branched substituent groups can be employed. For example, D₁ can be a straight or branched C8 alkyl group.

The Cp compound can include one or more additional substituent(s) Dₓ. Specific examples of Dₓ include:
A
Cₐ₁H_{b1}A_{c1},
Cₐ₂H_{b2}A_{c2}(C=O)Cₐ₁H_{b1}A_{c1},
Cₐ₂H_{b2}A_{c2}OCₐ₁H_{b1}A_{c1},
Cₐ₂H_{b2}A_{c2}(C=O)OCₐ₁H_{b1}A_{c1}, or
Cₐ₂H_{b2}A_{c2}O(C=O)Cₐ₁H_{b1}A_{c1},
where,
A is F, Cl, Br, I or NO₂;
a1 is an integer from 1 to 8;
b1 is an integer from 0 to 2(a1)+1 - c1;
c1 is an integer from 0 to 2(a1)+1 - b1;
b1 + c1 is equal to or greater than 1;
a2 is an integer from 0 to 8;
b2 is an integer from 0 to 2(a2)+1 - c2;
c2 is an integer from 0 to 2(a2)+1 - b2; and
b2 + c2 is equal to or greater than 1.

Specific examples of Cp compound include, methylcyclopentadiene, ethylcyclopentadiene, isopropylcyclopentadiene, tert-butylcyclopentadiene and others. Each of the MXₙ, L and Cp components can be provided in neat form or can optionally include a suitable solvent. Preferred solvents that can be employed in the method of the invention include alcohols, such as, for instance, ethanol, methanol, isopropanol and other alcohols. Ethyl acetate, tetrahydrofuran (THF), saturated or unsaturated hydrocarbons, aromatic heterocycles, alkyl halides, silylated hydrocarbons, ethers, polyethers thioethers, esters, lactones, amides, amines, polyamines, nitriles, silicone oils and other aprotic solvents also can be employed. Combinations of solvents also can be employed.

Generally, concentrations of MXₙ, L and Cp are selected as known in the art. For example, the molar concentration of MXₙ in a suitable solvent can be in the range of from about 0.1 M to neat. That of L in a suitable solvent can be in the range of from about 0.1 M to neat. The molar concentration of Cp in a suitable solvent can be in the range of from about 0.1 to neat. If neat phosphine is employed, it is believed that the reaction would be highly exothermic. Methods and systems for dissipating substantial amounts of heat of reaction per unit volume are known in the art.

The three components can be combined in any order. In one example, the metal component and the HCp component are added concurrently to the L component. In another embodiment, the metal component and the HCp component are combined to form a mixture and then the mixture is combined with the L component, for instance by adding the L component to the mixture. In yet another embodiment, all components are combined at the same time.

Typically the molar ratio of HCp to MXₙ used is in the range from about 50 to about 1, preferably from about 12 to about 2 and most preferably in the range from about 7 to about 5. Typically, the molar ratio of L to MXₙ is in the range of from about 8 to about 0, preferably from about 6 to about 2 and most preferably from about 5 to about 3.5. If a large excess amount of HCp component is employed, the reaction is driven to forming (Cp)₂M product.

The reaction temperature preferably is around the boiling point of the solvent employed or the boiling point of the reaction mixture. Other suitable temperatures can be determined by routine experimentation. Generally, the reaction can be conducted at a temperature that is in the range of from above the freezing point to about the boiling point of the reaction composition. For instance, the reaction can be conducted at a temperature in the range of from about -100°C to about 150°C.

The time of reaction generally depends on temperature, and concentration of the various reactants, and can range, for example, from about 5 minutes to about 96 hours.

The intermediate compound formed by the reaction of the metal salt (MXₙ), L and Cp compound, e.g., HCp, can be represented by the formula CpML_{f}X, where f = 1 or 2.

In one example, CpML_{f}X is isolated, e.g., as a solid, by methods known in the art. Examples of techniques that can be employed to isolate the intermediate compound include filtration, centrifugation and recrystallization.

In another example, no isolation of an intermediate compound from the reaction solution is carried out.

Whether isolated or not, the intermediate compound is reacted with a Cp' compound, preferably in the presence of a solvent.

Cp' preferably is provided as an anion in combination with a counterion, e.g., TMS, Na, Li, K, Mg, Ca, Tl. Specific examples of cyclopentadienide, or cyclopentadienide-like salts that can be employed to provide the Cp' moiety include KCp', LiCp', NaCp' and others.

Cp' can be unsubstituted or substituted. In a preferred embodiment, at least one H atom in the Cp' moiety is replaced by a substituent group D₁'. D₁' can be the same or different from D₁. Examples of D₁' include:
A;
Cₐ₁H_{b1}A_{c1};
Cₐ₂H_{b2}A_{c2}(C=O)Cₐ₁H_{b1}A_{c1};
Cₐ₂H_{b2}A_{c2}OCₐ₁H_{b1}A_{c1};
Cₐ₂H_{b2}A_{c2}(C=O)OCₐ₁H_{b1}A_{c1}; and
Cₐ₂H_{b2}A_{c2}O(C=O)Cₐ₁H_{b1}A_{c1};
where
A is F, Cl, Br, I or NO₂;
a1 is an integer from 1 to 8;
b1 is an integer from 0 to 2(a1)+1 - c1
c1 is an integer from 0 to 2(a1)+1 - b1;
b1 + c1 is at least 1;
a2 is an integer from 0 to 8;
b2 is an integer from 0 to 2(a2) + 1 - c2;
c2 is an integer from 0 to 2(a2) + 1 - b2.

Straight as well as branched substituent groups can be employed. For example, D₁' can be a straight or branched C8 alkyl group.

The Cp' compound can include one or more additional substituent(s) Dₓ'. Specific examples of Dₓ' include:
A
Cₐ₁H_{b1}A_{c1},
Cₐ₂H_{b2}A_{c2}(C=O)Cₐ₁H_{b1}A_{c1},
Cₐ₂H_{b2}A_{c2}OCₐ₁H_{b1}A_{c1},
Cₐ₂H_{b2}A_{c2}(C=O)OCₐ₁H_{b1}A_{c1}, or
Cₐ₂H_{b2}A_{c2}O(C=O)Cₐ₁H_{b1}A_{c1}
where,
A is F, Cl, Br, I or NO₂;
a1 is an integer from 0 to 8
b1 is an integer from 0 to 2(a1)+1 - c1
c1 is an integer from 0 to 2(a1)+1 - b1
b1 + c1 is equal to or greater than 1
a2 is an integer from 0 to 8
b2 is an integer from 0 to 2(a2)+1 - c2
c2 is an integer from 0 to 2(a2)+1 - b2
b2 + c2 is equal to or greater than 1

In specific examples of the invention, intermediate CpML_{f}X is reacted with sodium or lithium ethylcyclopentadienide, sodium or lithium methylcyclopentadienide, sodium or lithium isopropylcyclopentadienide and others. Di- or multi-substituted (e.g., tri-, tetra- or penta-substituted) cyclopentadienyl anions, in combination with a counter ion, as described above, also can be employed. Anions of substituted or unsubstituted indenes, cyclic poly-olefins, polycyclic unsaturated hydrocarbons, heterocycles, aromatic rings also can be used.

In one example, the intermediate compound is CpRu(PPh₃)₂Cl. It is reacted with a salt of Cp'. Recommended salts of Cp' include NaCp', LiCp', (Cp')₂Mg, TMS(Cp') and (Cp')Tl.

Examples of suitable solvents for conducting the reaction between CpML_{f}A and the Cp' component include benzene, toluene, xylenes, pentanes, hexanes, petroleum ether, aromatic heterocycles, saturated or unsaturated hydrocarbons, alkyl halides, silylated hydrocarbons, ethers, polyethers, thioethers, esters, lactones, amides, amines, polyamines, nitriles, silicones, and others.

Generally, the molar concentrations of the Cp' component in a solvent can be in the range of from about 0.1 M to about 3.5 M, preferably in the range of from about 0.5 M to about 2.5 M and most preferably in the range of from about 1.4 to about 1.8 M.

Typically, the molar ratio of Cp' relative to the CpML_{f}X is in the range from about 50 to about 1, preferably from about 6 to about 1 and most preferably from about 1.6 to about 1.2.

The reaction between the Cp' compound and the intermediate compound (whether isolated or not) is conducted at a temperature such as generally described above and results in the formation of CpMCp' product.

The product of the reaction, CpMCp', can be isolated and or purified by methods known in the art, such as, for example, solvent, e.g., hexane, extraction followed by distillation, sublimation or chromatography or directly by distillation, sublimation or chromatography. Recrystallization, ultracentrifugation and other techniques also can be employed. Alternatively, the product can be employed in the reaction mixture without further isolation and or purification.

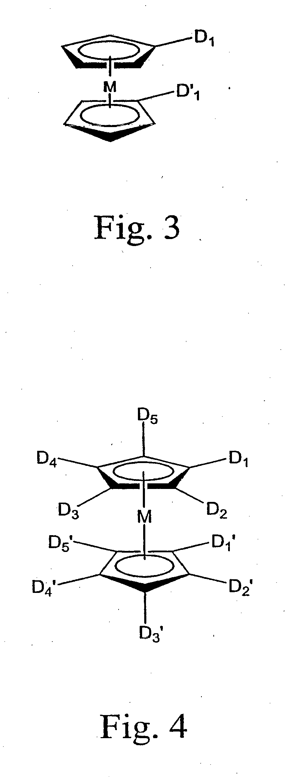

A structural formula of a metallocene compound produced by the method of the invention and that includes substituent groups D1 and D1' is shown in Fig. 3. A generalized structural formula of a metallocene compound is shown in Fig. 4. D₂, D₃, D₄, D₅, D₂', D₃', D₄', and D₅' can be independently selected from:
A
Cₐ₁H_{b1}A_{c1},
Cₐ₂H_{b2}A_{c2}(C=O)Cₐ₁H_{b1}A_{c1},
Cₐ₂H_{b2}A_{c2}OCₐ₁H_{b1}A_{c1},
Cₐ₂H_{b2}A_{c2}(C=O)OCₐ₁H_{b1}A_{c1}, or
Cₐ₂H_{b2}A_{c2}O(C=O)Cₐ₁H_{b1}A_{c1}
where,
A is F, Cl, Br, I or NO₂;
a1 is an integer from 1 to 8
b1 is an integer from 0 to 2(a1)+1 - c1
c1 is an integer from 0 to 2(a1)+1 - b1
b1 + c1 is equal to or greater than 1
a2 is an integer from 0 to 8
b2 is an integer from 0 to 2(a2)+1 - c2
c2 is an integer from 0 to 2(a2)+1 - b2
b2 + c2 is equal to or greater than 1

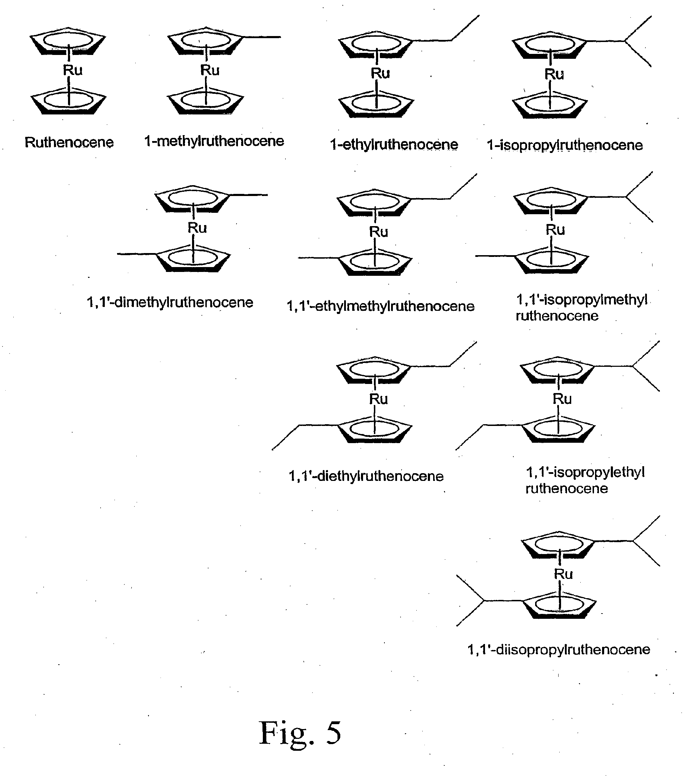

Specific examples of symmetric and asymmetric CpMCp' products that can be formed by this method are shown in Fig. 5. Some examples of asymmetric, disubstituted ruthenocenes that can be produced by the method described above are presented in Table 1.

| **Table 1** | |
|---|---|
| 1-methyl,1'-ethlruthenocene | 1,2-dimethyl,1'-ethylruthenocene |
| 1 -methyl,1'-propylruthenocene | 1-methyl,1',3-diethylruthenocene |
| 1-methyl,1'-isopropylruthenocene | 1-methyl,1',2-diethylruthenocene |
| 1-methyl,1'-butylruthenocene | 1-methyl,1'-ethyl,3-propylruthenocene |
| 1-methyl,1'-secbutylruthenocene | 1-methyl,1'-propyl,3-ethylruthenocene |
| 1-methyl,1'-tertbutylruthenocene | 1-ethyl,1'-methyl,3-propylruthenocene |
| 1-ethyl,1'-propylruthenocene | 1 -methyl,1'-ethyl,2-propylruthenocene |
| 1-ethyl,1'-isopropylruthenocene | 1-methyl,1'-propyl,2-ethylruthenocene |
| 1-ethyl,1'-butylruthenocene | 1-ethyl,1'-methyl,2-propylruthenocene |
| 1-ethyl,1'-secbutylruthenocene | 1-methyl, 1'-propylruthenocene |
| 1-ethyl,1'-tertbutylruthenocene | 1-methyl-1'-ethylruthenocene |
| 1-propyl,1'-isopropylruthenocene | 1,3-dimethyl-1'-ethylruthenocene |
| 1-propyl,1'-butylruthenocene | 1,2,1'-dmethyl-3'-ethylruthenocene |
| 1-propyl,1'-secbutylruthenocene | 1-butyl-1'-acetylruthenocene |
| 1-propyl,1'-tertbutylruthenocene | 1-ethyl-1'-methoxyruthenocene |
| 1-isopropyl,1'-butylruthenocene | 1-ethyl-1'-methoxy-2-ethoxyruthenocene |
| 1-isopropyl,1'-secbutylruthenocene | 1,2,3,4-tetramethyl-1'-ethylruthenocene |
| 1 -isopropyl,1'-tertbutylruthenocene | 1-acetyl,1'-ethoxyruthenocene |
| 1-butyl,1'-secbutylruthenocene | 1-difluoromethyl-1'-ethylruthenocene |
| 1-butyl,1'-tertbutylruthenocene | 1-trifluoromethyl,2,3,4-fluoro-1'-triflouromethylruthenocene |
| 1-secbutylruthenocene,1'-tertbutylruthenocene | 1-ethenyl-1'-fluororuthenocene |
| 1,1',3-trimethylruthenocene | 1-ethoxymethyl-1',2'-diethylruthenocene |
| 1,1',2-trimethylruthenocene | 1-ethyl,1'-propanoylruthenocene |
| 1,3-dimethyl,1'-ethylruthenocene | 1,1',2,4-tetraethyl-3'-acetylruthenocene |

The method of the invention also can be used to form osmium-based compounds and iron-based compounds similar to those shown in Fig 5 and Table 1. Similarly, the method of the invention can be used to form metallocenes including other η^{m}-coordinated aromatic moieties.

Asymmetric metallocene and asymmetric metallocene-like compounds that can be produced by the method of the invention also are described in U.S. Patent Application by David M. Thompson and Cynthia A. Hoover, with the title *Asymmetric Group 8 (VIII) Metallocene Compounds,* filed concurrently herewith under Attorney Docket Number D-21266.

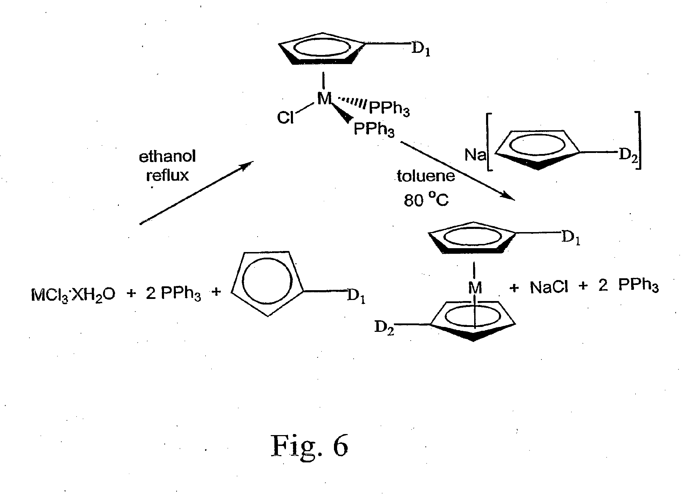

One specific embodiment of the method of the invention is described by the chemical reaction shown in Fig. 6. In the method depicted in Fig. 6, MCl₃·XH₂O, triphenylphosphine and a cyclopentadiene react in ethanol, under reflux, to form intermediate compound CpM(PPh₃)₂Cl, which then reacts with a sodium ethylcyclopentadienide to form CpMCp. The D₁ and D₂ substituents seen in Fig. 6 are independently selected as described above.

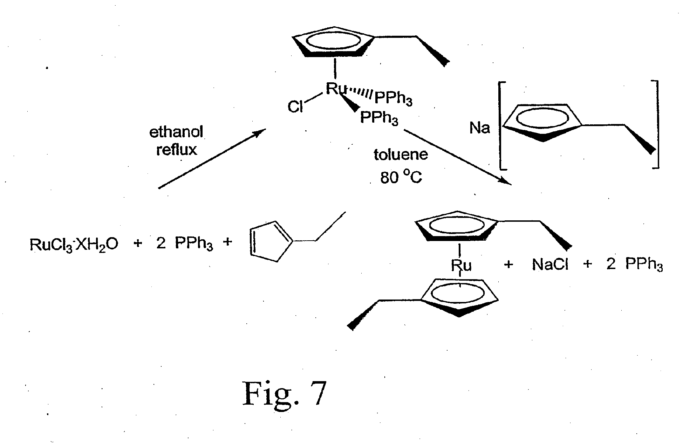

A specific synthetic scheme for forming 1,1=-diethylruthenocene is shown in Fig. 7. As shown in Fig. 7, RuCl₃·XH₂O, triphenylphosphine and ethylcyclopentadiene react in ethanol, under reflux, to form intermediate compound chloro(ethylcyclopentadienyl)bis(triphenylphosphine)ruthenium (II) or (η⁵-C₅H₄C₂H₅)Ru(PPh₃)₂Cl, which then reacts with a sodium ethylcyclopentadienide to form 1,1'-diethylruthenocene.

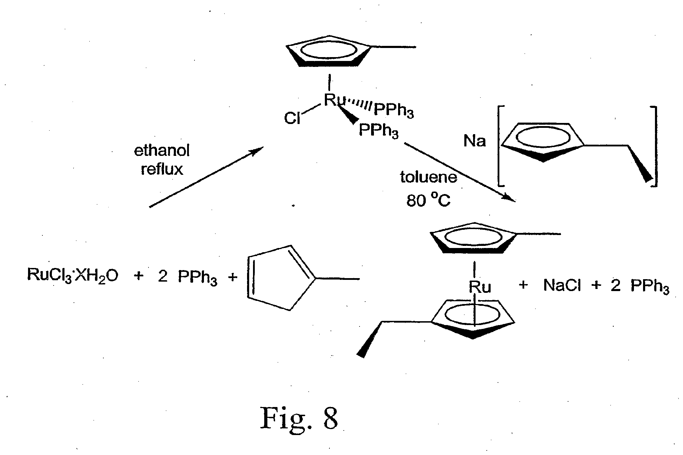

A synthetic scheme that can be employed to form a specific di-substituted asymmetric ruthenocene, i.e., 1-methyl, 1'-ethylruthenocene or (methyl-cycplopentadienyl)ethylcyclopentadienyl)ruthenium), is shown in Fig. 8. As shown in Fig. 8, RuCl₃·XH₂O, triphenylphosphine and methylcyclopentadiene react in ethanol, under reflux, to form intermediate compound chloro(methylcyclopentadienyl)bis(triphenylphosphine)rutheniu m(II) or (η⁵-C₅H₄C₂H₅)Ru(PPh₃)₂Cl, which then reacts with a sodium ethylcyclopentadienide to form 1-methyl,1'-ethylruthenocene.

When synthesizing structures of the type CpRuCp' in which Cp or Cp' includes a ketone, ester or ether functionality, it is preferred that the ring with the greater number of ketones, esters or ethers is identified as the Cp' ring, and that it is added to the intermediate as a TMS salt.

To produce symmetrical metallocenes, e.g., 1, 1'-diethylruthenocene, or symmetrical metallocene-like compounds, the method of the invention is modified as follows. A metal (M) salt (X) component and a ligand (L) component are combined to form an intermediate compound. MX₃·ηH₂O, for example, is combined with triphenylphosphine to form MX₂(PPh₃)ₘ, where m = 3 or 4. The intermediate compound can be isolated or is employed without being isolated. The intermediate compound, isolated or in the reaction mixture, is reacted with a Cp' component such as described above.

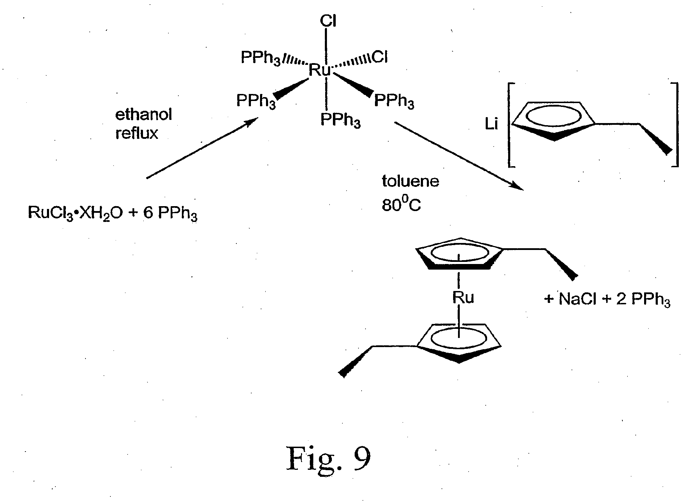

A specific example of this synthetic route is shown in Fig. 9. As shown in Fig. 9, RuCl₃·XH₂O is reacted with triphenylphosphine to form RuCl₂(PPh₃)₄.
RuCl₂(PPh₃)₃ can also be formed. This intermediate compound is then reacted with a lithium ethylcyclopentadienide to form 1,1'-diethylruthenocene.

The method of this embodiment of the invention also can be conducted by reacting an intermediate compound, e.g., RuCl₂(PPh₃)₃ or RuCl₂(PPh₃)₄, that is obtained commercially or is synthesized in a different manner, with a Cp' component, as described above.

The metallocene and metallocene-like compounds produced by the method of the invention are useful in scientific research, for example, in the study and understanding of organometallic chemistry of ferrocene and ferrocene-like molecules and in chemical reactions.

It is believed that the compounds prepared by the method of the invention also can be employed as combustion modifiers for solid propellants. It is believed that in some cases, functionalization of the parent ferrocene may prevent migration of the ferrocene from the rubber like binder matrix of the solid propellant into the surrounding insulation material. Metallocene and metallocene-like compounds prepared as described herein also might find uses as catalysts, for instance, in zeolite-impregnated metallocene catalysts for the reduction of nitrogen oxides or as catalysts in chiral organic synthesis; as iron deficiency supplements for animals and plants; as antioxidants and antiknock agents; as additives for motor fuels and oils; as color pigments; as radiation absorberes; and as insecticides and fungicides.

Metallocene compounds prepared by the method of the invention are particularly useful as precursors in film deposition processes, e.g., CVD processes. Such processes using asymmetric, disubstituted metallocene precursors are described in the U.S. Patent Application by David M. Thompson, Cynthia A. Hoover, John D. Peck and Michael M. Litwin, entitled *Deposition Processes Using Group 8 (VIII) Metallocene Precursors,* filed concurrently herewith under Attorney Docket No. D-21267.

### EXEMPLIFICATION

### EXAMPLE 1

### STEP A

A 2 L three-necked round bottomed flask was charged with a Teflon® (perfluorinated polymer, DuPont Corp.) stirring bar, ethanol (1.0 L) and PPh₃ (263 g, 1.0 mol). A 250 mL dropping funnel, a 150 mL bath-jacketed dropping funnel, and a condenser were attached to the three necks of the 2L flask. It is important to note that both dropping funnels were equipped with Teflon® (perfluorinated polymer, DuPont Corp.) valves that permitted their isolation from the atmosphere of the round-bottomed flask. A rubber septum was connected to the top of the 150 mL bath-jacketed dropping funnel. The top of the condenser was fitted with an T junction adapter and connected to an inert atmosphere. A heating mantle was placed beneath the 2 L three-necked round-bottomed flask and the solution was stirred and heated to reflux. At reflux all of the triphenylphosphine dissolved in the ethanol. The system was purged with nitrogen for 3 hours while at reflux.

While this was taking place a 500 mL erlenmyer flask was charged with RuCl₃·XH₂O (50 g, 0.20 mol), ethanol (150 mL) and a Teflon® (perfluorinated polymer, DuPont Corp.) coated magnetic stirring bar. The ethanolic solution immediately developed a brown/orange colour. To dissolve all of the RuCl₃·XH₂O it was necessary to slowly heat the solution. This solution was poured into the 250 mL.

While this was taking place a 500 mL erlenmyer flask was charged with RuCl₃·XH₂O (50 g, 0.20 mol), ethanol (150 mL) and a Teflon® (perfluorinated polymer, DuPont Corp.) coated magnetic stirring bar. The ethanolic solution immediately developed a brown/orange colour. To dissolve all of the RuCl₃·XH₂O it was necessary to slowly heat the solution. This solution was poured into the 250 mL dropping-funnel and the dropping-funnel was fitted with a rubber septum. This solution was sparged with nitrogen for 30 minutes by inserting a needle connected to a 1-2 pounds per square inch gauge (psig) nitrogen source through the septum and into the solution and by piercing the septum with another needle to allow for relief of excess pressure.

A methanol/dry ice bath was made up in the 150 mL bath-jacketed dropping funnel. The interior of this dropping funnel was purged with nitrogen for 30 minutes in a similar fashion to which the other dropping funnel was sparged. Ethylcyclopentadiene (116 g, 1.2 mol, freshly distilled under a nitrogen atmosphere) was then cannulated into the cooled dropping funnel through the rubber septum.

After the 3 hours of purging the 2 L-round bottomed flask had elapsed, the Teflon® (perfluorinated polymer, DuPont Corp.) valves isolating the dropping funnels from the rest of the system were both opened and dropwise addition of the two solutions commenced simultaneously. Over the course of 20 minutes the two solutions were both added to the ethanolic PPh₃ solution. During this entire time the solution was at reflux. The solution quickly developed a deep orange brown color.

After the addition was completed the solution was left to reflux for an additional 2 hours. During this time small red crystals could be seen accumulating above the meniscus of the solution on the walls of the 2 L flask.

### STEP B

The solution was allowed to cool to slightly below reflux and the contents of the 2 L flask were filtered (open to air) over a coarse frit. The red/orange solid was collected (198 g). The filtrate was discarded and the solid was placed in a vacuum oven at 60°C overnight.

The solution was allowed to cool to slightly below reflux and the contents of the 2 L flask were filtered (open to air) over a coarse frit. The red/orange solid was collected (198 g). The filtrate was discarded and the solid was placed in a vacuum oven at 60°C overnight.

The solid was removed from the vacuum oven and tared on an analytical balance (150.2g). Based on this, the yield of crude chloro(ethylcyclopentadienyl)bis(triphenylphosphine)ruthenium(II) was determined to be >99%.

### STEP C

Next, in a nitrogen glovebox, a 1 L flask was charged with toluene (500 mL, anhydrous), the crude chloro(ethylcyclopentadienyl)bis(triphenylphosphine)ruthenium (II) (150g, 0.20 mol) and a Teflon® (perfluorinated polymer, DuPont Corp.) stir bar. The solution was stirred and sodium ethylcyclopentadienide (41 g, 0.35 mol) was slowly added over the course of one hour. Following this addition the solution was stirred for 4 hours at 80°C. At this stage the flask was removed from the glovebox and the majority of toluene was removed using a rotary evaporator. Hexanes (500 mL) was then added to the flask and the contents were stirred for 30 minutes. This solution was then filtered through a plug of silica over a coarse frit. A brown/red solid was separated from the yellow/orange filtrate. The filtrate was then placed in a freezer and a crystalline solid (PPh₃) precipitated from the solution. The liquid was decanted from the solid and the solution was again concentrated using a rotary evaporator. This solution was left overnight and crystals (PPh3) were evident in the flask the following morning. The liquid was decanted into a 100 mL round-bottomed flask.

The 100 mL round-bottomed flask was fitted with a short path distillation adapter with vigreux indentations and a 100 mL storage flask receptacle. The liquid was distilled under vacuum and a clear yellow liquid, 1,1'-diethylruthenocene containing 3% triphenylphosphine (determined by GCMS and 1H NMR). Spinning band distillation of the yellow liquid afforded 47.6 g (83% yield) of triphenylphosphine free 1,1'-diethylruthenocene in >99.7+% purity (GCMS), with the remaining impurities being attributable to 1-ethylruthenocene and ruthenocene. TGA studies showed that this liquid had less than 0.0001% nonvolatile residue.

### EXAMPLE 2

### STEP A

The procedure of step A was the same as described in Example 1, above.

Specifically, a 2 L three-necked round bottomed flask was charged with a Teflon® (perfluorinated polymer, DuPont Corp.) stirring bar, ethanol (1.0 L) and PPh₃ (263 g, 1.0 mol). A 250 mL dropping funnel, a 150 mL bath-jacketed dropping funnel, and a condenser were attached to the three necks of the 2L flask. Both dropping funnels were equipped with Teflon® (perfluorinated polymer, DuPont Corp.) valves that permitted their isolation from the atmosphere of the round-bottomed flask. A rubber septum was connected to the top of the 150mL bath-jacketed dropping funnel. The top of the condenser was fitted with a T junction adapter and connected to an inert atmosphere. A heating mantle was placed beneath the 2L three-necked round-bottomed flask and the solution was stirred and heated to reflux. At reflux all of the triphenylphosphine dissolved in the ethanol. The system was purged with nitrogen for 3 hours while at reflux.

Meanwhile, a 500 mL Erlenmyer flask was charged with RuCl₃·XH₂O (50 g, 0.20 mol), ethanol (150 mL) and a Teflon® (perfluorinated polymer, DuPont Corp.) coated magnetic stirring bar. The ethanolic solution immediately developed a brown/orange color. To dissolve all of the RuCl₃·XH₂O it was necessary to gently heat the solution. This solution was poured into the 250 mL dropping funnel and the dropping funnel was fitted with a rubber septum. This solution was sparged with nitrogen for 30 minutes by inserting a needle connected to a 1-2 pounds per square inch gauge (psig) nitrogen source through the septum and into the solution and by piercing the septum with another needle to allow for relief of excess pressure.

A methanol/dry ice bath was prepared in the 150 mL bath-jacketed dropping funnel. The interior of this dropping funnel was purged with nitrogen for 30 minutes in a similar fashion to which the other dropping funnel was sparged. Ethylcyclopentadiene (116 g, 1.2 mol, freshly distilled under a nitrogen atmosphere) was then cannulated into the cooled dropping funnel through the rubber septum.

After the 3 hours of purging the 2 L-round bottomed flask had elapsed, the Teflon® (perfluorinated polymer, DuPont Corp.) valves isolating the dropping funnels from the rest of the system were both opened and dropwise addition of the two solutions commenced simultaneously. Over the course of 20 minutes the two solutions were both added to the ethanolic PPh₃ solution. During this entire time the solution was at reflux. The solution quickly developed a deep orange brown color.

### STEP B

Additional ethylcyclopentadiene (116 g, 1.2 mol, freshly distilled under a nitrogen atmosphere) was cannulated into the cooled dropping funnel through the rubber septum as before. The ethylcyclopentadiene was slowly added over the course of 30 minutes while the ethanolic solution continued to reflux.

The solution was allowed to stir for an additional 3 hours. The 2 dropping funnels and the condenser are removed from the 2L flask and the solution was filtered (while open to air) through a coarse frit. The filtrate was concentrated using reduced pressure (to less than 200 mL). The filtrate was then transferred to a 250 mL round-bottomed flask fitted with a short path distillation adapter with Vigreux indentations to which a 100 mL storage flask receptacle was connected. The liquid was distilled under vacuum and a clear yellow liquid, 1,1= Bdiethylruthenocene was obtained in 12% yield.

### EXAMPLE 3

### STEP A

A procedure similar to Example I (Step A) was employed. A 5 L five-necked round bottomed flask was equipped with a mechanical stirring paddle through the central neck. It was then charged with ethanol (2.0 L) and PPh3 (420 g, 1.6 mol). Two 500 mL three necked flasks, were connected to two necks of the 5L four-necked flask via Teflon® (perfluorinated polymer, DuPont Corp.) tubing through positive displacement pumps. The remaining neck of the 5 L flask was equipped with a condenser. A heating mantle was placed beneath the 5L flask and the solution was stirred and heated to reflux. At reflux all of the triphenylphosphine dissolved in the ethanol. The system was purged with nitrogen for 30 minutes while at reflux.

While this was taking place one of the 500 mL round-bottomed flasks was charged with RuCl₃·XH₂O (100 g, 0.40 mol), ethanol (300 mL) and a Teflon® (perfluorinated polymer, DuPont Corp.) coated magnetic stirring bar. The ethanolic solution immediately developed a brown/orange colour. To dissolve all of the RuCl₃·XH₂O it was necessary to heat the solution. This solution was sparged with nitrogen for 30 minutes by inserting a needle connected to a 1-2 pounds per square inch gauge (psig) nitrogen source through the septum and into the solution and by piercing the septum with another needle to allow for relief of excess pressure.

An acetonitrile/dry ice bath was made up and the other 500 mL flask was immersed into this bath. Freshly distilled methylcyclopentadiene (190 g, 270 mL, 2.4 mol, freshly distilled under a nitrogen atmosphere) was then cannulated into the cooled flask.

After the nitrogen sparging of the ethanolic solutions of triphenylphosphine and ruthenium trichloride had completed, the contents of the two 500 mL flasks were pumped into the 5.0 L flask by positive displacement pumps at independent rates so that both additions completed after 5 minutes. To accomplish this the ethylcyclopentadiene was pumped in at a rate of 45 mL/min and the ethanolic ruthenium trichloride was pumped in at a rate of 50 mL/min.

After the addition had been completed the solution was left to reflux for an additional 2 hours. During this time small orange crystals could be seen accumulating above the meniscus of the solution on the walls of the 2 L flask.

### STEP B

The two positive displacement pumps and Teflon® (perfluorinated polymer, DuPont Corp.) lines were disconnected from the 5 L flask after the 2 hours of stirring. A distillation sidearm was connected one of the necks of the flask and approximately 1 L of ethanol was removed via distillation. Mechanical stirring was discontinued and the orange crystals settled to the bottom of the flask. The solution cooled to room temperature over 3 hours. The solution was then removed from the flask by inserting a piece of glass tubing with a coarse frit attached to the end of it and using reduced pressure to draw the solution through the frit and out of the flask. The crystals were washed with heptane (300 mL) and the heptane was removed in a similar fashion. The washing was carried out three times.

### STEP C

All of the open ports to the flask were sealed with rubber septa and the flask was evacuated and refilled with nitrogen three times. THF (500 mL, anhydrous) was cannulated into the flask and mechanical stirring was initiated. A THF solution of lithium ethylcyclopentadiene (500 mL, 1.2 M, 0.60 mol) was then cannnulated into the 5 L flask. The contents were heated to reflux and stirred for 4 hours.

After the 4 hours of reflux, stirring was discontinued and the solution was transferred to a 2 L one necked round bottomed flask. This solution was concentrated to a volume of approximately 200 mL on a rotary evaporator. The viscous liquid was then transferred to a 250 mL round bottomed flask.

The 250 mL round-bottomed flask was fitted with a short path distillation adapter with vigreux indentations and a 100 mL storage flask receptacle. The liquid was distilled under vacuum and a clear yellow liquid, 1-methyl, 1'-ethylruthenocene containing some triphenylphosphine (determined by GCMS). Spinning band distillation of the yellow liquid afforded 84.6 g (82% yield) of triphenylphosphine free 1-methyl, 1'-ethylruthenocene in >99% purity (GCMS, 1H NMR), with the remaining impurities being attributable to 1,1'-dimethylruthenocene and 1,1'-diethylruthenocene. TGA studies showed that this liquid had less than 0.01% nonvolatile residue.

### EXAMPLE 4

A 2 L three-necked round bottomed flask was charged with a Teflon® (perfluorinated polymer, DuPont Corp.) stirring bar, ethanol (1.0 L) and PPh₃ (263 g, 1.0 mol, 5 eq). A 250 mL dropping funnel, a 150 mL bath-jacketed dropping funnel, and a condenser were attached to the three necks of the 2L flask. It is important to note that both dropping funnels were equipped with Teflon® (perfluorinated polymer, DuPont Corp.) valves that permitted their isolation from the atmosphere of the round-bottomed flask. A rubber septum was connected to the top of the 150 mL bath-jacketed dropping funnel. The top of the condenser was fitted with an T junction adapter and connected to an inert atmosphere. A heating mantle was placed beneath the 2 L three-necked round-bottomed flask and the solution was stirred and heated to reflux. At reflux all of the triphenylphosphine dissolved in the ethanol. The system was purged with nitrogen for 3 hours while at reflux.

While this was taking place a 500 mL erlenmyer flask was charged with RuCl₃·XH₂O (50 g, 0.20 mol), ethanol (150 mL, 1 eq) and a Teflon® (perfluorinated polymer, DuPont Corp.) coated magnetic stirring bar. The ethanolic solution immediately developed a brown/orange colour. To dissolve all of the RuCl₃·XH₂O it was necessary to gently heat the solution. This solution was poured into the 250 mL dropping funnel and the dropping funnel was fitted with a rubber septum. This solution was sparged with nitrogen for 30 minutes by inserting a needle connected to a 1-2 psig nitrogen source through the septum and into the solution and by piercing the septum with another needle to allow for relief of excess pressure.

A methanol/dry ice bath was made up in the 150 mL bath-jacketed dropping funnel. The interior of this dropping funnel was purged with nitrogen for 30 minutes in a similar fashion to which the other dropping funnel was sparged. Methylcyclopentadiene (96.2 g, 1.2 mol, 6 eq, doubly distilled under a nitrogen atmosphere) was then cannulated into the cooled dropping funnel through the rubber septum.

After the 3 hours of purging the 2 L-round bottomed flask had elapsed, the Teflon® (perfluorinated polymer, DuPont Corp.) valves isolating the dropping funnels from the rest of the system were both opened and dropwise addition of the two solutions commenced simultaneously. Over the course of 20 minutes the two solutions were both added to the ethanolic PPh₃ solution. During this entire time the solution was at reflux. The solution quickly developed a deep orange brown color. After the addition had been completed the solution was left to reflux for an additional 2 hours. During this time small orange crystals of CpRu(PPh₃)₂Cl could be seen accumulating above the meniscus of the solution on the walls of the 2 L flask.

A piece of tubing with a coarse porous frit attached to one end was attached to a positive displacement pump. The fritted end of the tubing was immersed in the reactor and all of the liquids were pumped out of the 2L round-bottomed flask. At this stage the dropping funnels were removed from the reactor. One side was fitted with a K-Head distillation adapter and the other side was fitted with a rubber septum. The flask was evacuated and refilled with nitrogen three times. Working under nitrogen, anhydrous toluene (1.0 L) was cannulated into the 5 L flask through the rubber septum. The dark opaque solution was heated to reflux and the K-head distillation adapter was opened to distill off a fraction of the solvent. Distillate was collected until the head temperature reached 109°C (It is important to note that in different experiments this consumes different volumes of solvent - typically 400-600 mL of liquid). The solution was then cooled to below reflux.

The flask was then charged with additional toluene to obtain a volume of approximately 600 mL toluene. A lithium ethylcyclopentadienide slurry of toluene (35 g, 0.35 mol, 400 mL) was then cannulated into the reaction pot. Following this addition the solution was stirred for 4 hours at 80°C. At this stage the flask was removed from the glovebox and the majority of toluene was removed using a K-head distillation adapter.

The remaining liquid (approximately 400 mL) was decanted into a 1.0 L round-bottomed flask. This round-bottomed flask was fitted with a short path distillation adapter with vigreux indentations and distilled. The liquid collected from the vigreux column was distilled again using spinning band distillation under vacuum and 44 g of a clear yellow liquid, 1-methyl,1'-ethylruthenocene was obtained in >99% purity (GCMS). TGA studies showed that this liquid had less than 0.01% nonvolatile residue.

### EXAMPLE 5

Lithium(ethylcyclopentadienide) was produced as follows. A 2 L three-necked jacketed round bottomed flask was charged with a Teflon® (perfluorinated polymer, DuPont Corp.) stirring bar. A stopcock adapter, a thermowell adapter with thermowell and a rubber septum were fitted to the three necks of the flask. A nitrogen/vacuum manifold was connected to the stopcock adapater and the flask was evacuated and refilled with nitrogen 3 times. Anhydrous toluene (1.0 L) was then cannulated into the flask through the rubber septum and stirring was initiated. A cold fluid circulator was connected to the outer jacket of the jacketed flask with nalgene tubing and a cold fluid (-15°C) was circulated through the outside wall of the jacketed flask. Once the toluene reached -10°C, freshly distilled ethylcyclopentadiene (middle cut distilled on a vigreux column) was cannulated into the flask (127 g, 1.35 mol). While stirring, n-butyllithium (800 mL, 1.6 M in hexanes, 1.28 mol) was slowly cannulated at a rate that kept the temperature below 0°C (approximately 2 hours). During the addition of the n-butyllithium a fine white precipitate (lithium ethylcyclopentadienide) became evident in the solution.

This material could be used as a suspension or isolated as a solid via filtration and removal of solvent.

### EXAMPLE 6

A 5 L three-necked round bottomed flask with a thermowell was fitted with a 250 mL addition funnel, a 24/40 stopper, and a K-head distillation adapter equipped with a spiral condenser and a 10/30 thermowell. To this apparatus, denatured ethanol (2.0 L) and PPh₃ (790 g, 3.01 mol 6 eq) were added. Only a small fraction of the PPh₃ was dissolved at this stage. The contents of the flask were purged with nitrogen for 30 minutes while it was mechanically stirred. Following the N₂ purge the solution was heated to reflux with a heating mantle. The solution is clear and colorless at this point.

While the solution is heated to reflux, RuCl₃··XH₂O (124 g, 0.50 mol 1 eq) was dissolved in ethanol (250 mL) in a 500 mL Erlenmyer Flask. It was necessary to heat the solution to 50°C to dissolve all of the RuCl₃·XH₂O. This opaque brown colored solution was transferred to the addition funnel. It was then purged with N₂ for 15 minutes in the addition funnel.

The ethanolic RuCl₃·XH₂O solution was added over the course of 25 minutes to the refluxing ethanolic PPh₃ solution below. The rate of addition was governed by an exotherm and the ability of the condenser to adequately condense the boiling ethanol. During the course of the addition small burgundy crystals became evident in the solution. Following the addition, the solution was stirred at reflux for an additional 1.5 hours. Following this, heating was discontinued and the contents of the flask were allowed to cool to room temperature with stirring. Stirring was discontinued at this point and the contents in the flask were exposed to air.

A piece of tubing with a coarse porous frit attached to one end was attached to a positive displacement pump. The fritted end of the tubing was immersed in the reactor and all of the liquids were pumped out of the 5 L round-bottomed flask. At this stage the reactor was sealed with a rubber septum and was evacuated and refilled with nitrogen three times. Working under nitrogen, anhydrous toluene (1.0 L) was cannulated into the 5 L flask through the rubber septum. The dark opaque solution was heated to reflux and the K-head distillation adapter was opened to distill off a fraction of the solvent. Distillate was collected until the head temperature reached 109°C the boiling point of toluene in their environment (it is important to note that in different experiments this consumes different volumes of solvent, typically 400-600 mL of liquid). The solution was then cooled to below reflux.

A toulene/hexane slurry of lithium ethylcyclopentadienide (1.28 mol, 1.9 L toluene/hexane, 2.6 eq) was then cannulated through ¼" tubing into the 5 L round-bottomed flask. Following this addition the solution develops a burgundy color. The reaction was subsequently heated to reflux for 4 hours. Over the course of the reflux the burgundy color was initially replaced by an orange color and orange crystals were evident. This then changed to a much darker solution and the orange crystals were consumed. The solvent was distilled off using the K-Head Distillation adapter to reduce the volume to approximately 900 mL. The remaining oil was transferred to a 2000 mL round-bottomed flask and a functional vacuum distillation was employed to obtain 1,1'-diethylruthenocene.

The 1,1'-diethylruthenocene obtained via this method was 97% pure. Further purification via spinning band distillation afforded an 84% yield (121 g) of 99.9+% (by GCMS) 1,1'diethylruthenocene. This material was 99.999+% pure on a metal basis (ICPMS) and had a non-volatile residue of <0.1%. It is likely unnecessary to employ spinning band distillation to achieve these purities.

### EXAMPLE 7

In a nitrogen glovebox, a 250 mL flask was charged with THF (50 mL, anhydrous, inhibitor free), chloro(ethylcyclopentadienyl)bis(triphenylphosphine)ruthenium (II) (3.22 g, 0.004 mol, 1 equivalent) and a Teflon® (perfluorinated polymer, DuPont Corp.) stirring bar. The solution was stirred and a burgundy colored THF solution of sodium isopropylcyclopentadienide was slowly added (0.20 M, 30 mL, 1.5 equivalents). Following the addition the solution developed a deep red color. Within 30 minutes, the meniscus appeared yellow in color. The solution was stirred overnight.

An aliquot (1.0 mL) was taken from the solution and was analyzed by GC/MS. A peak with a mass of 301 g/mol was observed consistent with the 1-ethyl-1'-isopropylruthenocene. Other peaks with masses consistent with the presence of alkylcyclopentadiene dimers, 1,1'-diethylruthenocene, 1,1'-diisopropylruthenocene and triphenylphosphine were also observed.

The THF solvent was then removed from the flask under reduced pressure. The 250 mL flask was fitted with a vacuum jacketed short path distillation adapter and the contents of the flask were distilled under reduced pressure(∼ 0.1 torr). A pale yellow liquid was collected (0.72 g). This liquid was then purified via chromatography. A silica gel in pentane solution was used. The column had a diameter of 0.75" and a 6" length. 0.53 g of 99+% pure 1-ethyl-1'-isopropylruthenocene were isolated via chromatography (41% yield).

### EXAMPLE 8

In a nitrogen glovebox, a 250 mL flask was charged with THF (50 mL, anhydrous, inhibitor free), chloro(methylcyclopentadienyl)bis(triphenylphosphine)rutheniu m(II) (5.02 g, 0.007 mol, 1 equivalent) and a Teflon® (perfluorinated polymer, DuPont Corp.) stirring bar. The solution was stirred and a burgundy colored THF solution of sodium isopropylcyclopentadienide was slowly added (0.20 M, 50 mL, 1.5 equivalents). Following the addition the solution developed a deep red color. Within 30 minutes, the meniscus appeared yellow in color. The solution was stirred overnight.

An aliquot (1.0 mL) was taken from the solution and was analyzed by GC/MS. A peak with a mass of 287 g/mol was observed consistent with 1-methyl-1'-isopropylruthenocene. Other peaks with masses consistent with the presence of alkylcyclopentadiene dimers, 1,1'-dimethylruthenocene, 1,1'-diisopropylruthenocene and triphenylphosphine were also observed.

The THF solvent was then removed from the flask under reduced pressure. The 250 mL flask was fitted with a vacuum jacketed short path distillation adapter and the contents of the flask were distilled under reduced pressure (∼ 0.1 torr). A pale yellow liquid was collected (1.78 g). This liquid was then purified via chromatography. A silica gel in pentane solution was used. The column had a diameter of 0.75" and a 6" length. 1.03 g of 98+% pure 1-methyl-1'-isopropylruthenocene were obtained after chromatography (53% yield).

### EXAMPLE 9

A 100 mL flask was charged with chloro(ethylcyclopentadienyl)bis(triphenylphosphine)ruthenium (II) (5.16 g, 0.007 mol, 1 equivalent) and a Teflon® (perfluorinated polymer, DuPont Corp.) stir bar. The flask was connected to a nitrogen/vacuum manifold and subjected to 3 evacuation/nitrogen refill cycles. THF (50 mL, anhydrous, inhibitor free) was cannulated into the 100 mL round-bottomed flask and the contents were stirred. A NaCp solution (2.0 M, 5 mL, 1.5 equivalent) was then cannulated into the 100 mL round-bottomed flask. The solution exhibited a deep burgundy color. The solution was stirred overnight.

The THF solvent was then removed from the flask under reduced pressure. The 100 mL flask was fitted with a short path distillation adapter and the contents of the flask were distilled under reduced pressure (∼ 0.1 torr). A pale yellow liquid was collected. This yellow liquid was purified using the same chromatographic method as described above for other dialkyldicylcopentadieneruthenium(II) species. 1.03 g of 98+% pure 1-ethylruthenocene were isolated.

### EXAMPLE 10

In a nitrogen glovebox, a 250 mL flask was charged with bis(propylcyclopentadienyl)magnesium (5.15 g, 0.02 mol, 1 equivalent), chloro(methylcyclopentadienyl) bis(triphenylphosphine)ruthenium(II) (5.02 g, 0.007 mol, 1 equivalent) and a Teflon® (perfluorinated polymer, DuPont Corp.) stirring bar. Toluene (120 mL, anhydrous, inhibitor free) was cannulated into the 250 mL round-bottomed flask and the contents were stirred. Following the addition of solvent the solution developed a deep red color.

The toluene solvent was then removed from the flask under reduced pressure. The toluene solvent was removed under reduced pressure and the flask was fitted with a short path distillation adapter. The distillate was collected and the GC/MS revealed that the main cut from the short path distillation was 88.7% pure 1-propyl-1'-ethylruthenocene.

## Claims

1. A method for producing a Group 8 (VIII) metallocene compound represented by the general formula CpMCp', comprising the steps of:
a) reacting a metal salt (MXₙ) compound, a Cp compound and a ligand (L) to form an intermediate compound, wherein MXₙ is an anhydrous or a hydrated metal halide or metal nitrate and L is a phosphine or a phosphine triester; and
b) reacting the intermediate compound with a Cp' compound to produce the metallocene compound, wherein,
M is selected from the group consisting of Ru, Os and Fe;
Cp is different from Cp', Cp and Cp' are η^{m}-coordinated moieties and are both unsubstituted or either or both of Cp and Cp' includes at least one substituent that is selected form the group consisting of:
A;
Cₐ₁H_{b1}A_{c1};
Cₐ₂H_{b2}A_{c2}(C=O)Cₐ₁H_{b1}Ac₁;
Cₐ₂H_{b2}A_{c2}OCₐ₁H_{b1}A_{c1}; Cₐ₂H_{b2}A_{c2}(C=O)OCₐ₁H_{b1}A_{c1}; and
Cₐ₂H_{b2}A_{c2}O(C=O)Cₐ₁H_{b1}A_{c1};
where
A is F, Cl, Br, I or NO₂;
a1 is an integer from 1 to 8;
b1 is an integer from 0 to 2(a1)+1 - c1;
c1 is an integer from 0 to 2(a1)+1 - b1;
b1 + c1 is at least 1;
a2 is an integer from 0 to 8;
b2 is an integer from 0 to 2(a2) + 1 - c2;
c2 is an integer from 0 to 2(a2) + 1 - b2; and
m is the number of carbon atoms in the cyclic moieties that are believed to be bonded to the metal atom.

2. The method of Claim 1, further including the step of isolating the intermediate compound.

3. The method of Claim 1, wherein the Cp compound is a substituted or unsubstituted cyclopentadiene and the Cp' compound is a cyclopentadienide salt.

4. The method of Claim 1, wherein either or both of step a) or step b) is conducted in a solvent medium.

5. The method of Claim 4, wherein either or both of step a) or step b) is conducted at the boiling temperature of the reaction mixture.

6. The method of Claim 1, wherein, either or both of Cp or Cp' includes at least one additional substituent selected from the group consisting of:
A
Cₐ₁H_{b1}A_{c1},
Cₐ₂H_{b2}A_{c2}(C=O)Cₐ₁H_{b1}A_{c1},
Cₐ₂H_{b2}A_{c2}OCₐ₁H_{b1}A_{c1},
Cₐ₂H_{b2}A_{c2}(C=O)OCₐ₁H_{b1}A_{c1}, or
Cₐ₂H_{b2}A_{c2}O(C=O)Cₐ₁H_{b1}A_{c1}
where,
A is F, Cl, Br, I or NO₂;
a1 is an integer from 0 to 8
b1 is an integer from 0 to 2(a1)+1 - c1
c1 is an integer from 0 to 2(a1)+1 - b1
b1 + c1 is equal to or greater than 1
a2 is an integer from 0 to 8
b2 is an integer from 0 to 2(a2)+1 - c2
c2 is an integer from 0 to 2(a2)+1 - b2
b2 + c2 is equal to or greater than 1.

## Patentansprüche

1. Verfahren zum Herstellen einer Gruppe-8(VIII)-Metallocenverbindung, die durch die allgemeine Formel CpMCp' dargestellt ist, die folgenden Schritte umfassend:
a) Umsetzen einer Metallsalz(MXₙ)-Verbindung, einer Cp-Verbindung und eines Liganden (L), um eine Zwischenverbindung auszubilden, wobei MXₙ ein wasserfreies oder hydriertes Metallhalogenid oder Metallnitrat ist und L ein Phosphin oder ein Phosphintriester ist; und
b) Umsetzen der Zwischenverbindung mit einer Cp'-Verbindung, um die Metallocenverbindung zu produzieren, wobei
M ausgewählt ist aus der Gruppe bestehend aus Ru, Os und Fe;
Cp sich von Cp' unterscheidet, Cp und Cp' η^{m}-koordinierte Gruppierungen sind und beide nicht substituiert sind oder eins oder beide von Cp und Cp' mindestens einen Substituenten beinhalten, der ausgewählt ist aus der Gruppe bestehend aus:
A;
Cₐ₁H_{b1}A_{c1};
Cₐ₂H_{b2}A_{c2}(C=O)Cₐ₁H_{b1}A_{c1};
Cₐ₂H_{b2}A_{c2}OCₐ₁H_{b1}A_{c1}; Cₐ₂H_{b2}A_{c2}(C=O)OCₐ₁H_{b1}A_{c1}; und
Cₐ₂H_{b2}A_{c2}O(C=O)Cₐ₁H_{b1}A_{c1};
wobei
A für F, Cl, Br, I oder NO₂ steht;
a1 für eine ganze Zahl von 1 bis 8 steht;
b1 für eine ganze Zahl von 0 bis 2(a1)+1-c1 steht;
c1 für eine ganze Zahl von 0 bis 2(a1)+1-b1 steht; b1+c1 mindestens 1 ist;
a2 für eine ganze Zahl von 0 bis 8 steht;
b2 für eine ganze Zahl von 0 bis 2(a2)+1-c2 steht;
c2 für eine ganze Zahl von 0 bis 2(a2)+1-b2 steht; und
m für die Anzahl an Kohlenstoffatomen in den cyclischen Gruppierungen steht, von denen angenommen wird, dass sie an das Metallatom gebunden sind.

2. Verfahren nach Anspruch 1, ferner beinhaltend den Schritt des Isolierens der Zwischenverbindung.

3. Verfahren nach Anspruch 1, wobei die Cp-Verbindung ein substituiertes oder nicht substituiertes Cyclopentadien ist und die Cp'-Verbindung ein Cyclopentadiensalz ist.

4. Verfahren nach Anspruch 1, wobei einer oder beide von Schritt a) oder Schritt b) in einem Lösungsmittelmedium durchgeführt wird/werden.

5. Verfahren nach Anspruch 4, einer oder beide von Schritt a) oder Schritt b) bei der Siedetemperatur des Reaktionsgemischs durchgeführt wird/werden.

6. Verfahren nach Anspruch 1, wobei eins oder beide von Cp oder Cp' mindestens einen zusätzlichen Substituenten beinhaltet(n), der ausgewählt ist aus der Gruppe bestehend aus:
A
Cₐ₁H_{b1}A_{c1},
C_{c2}H_{b2}A_{c2}(C=O)Cₐ₁H_{b1}A_{c1},
Cₐ₂H_{b2}A_{c2}OCₐ₁H_{b1}A_{c1},
Cₐ₂H_{b2}A_{c2}(C=O)OCₐ₁H_{b1}A_{c1}, oder
Cₐ₂H_{b2}A_{c2}O(C=O)Cₐ₁H_{b1}A_{c1}
wobei
A für F, Cl, Br, I oder NO₂ steht
a1 für eine ganze Zahl von 0 bis 8 steht
b1 für eine ganze Zahl von 0 bis 2(a1)+1-c1 steht
c1 für eine ganze Zahl von 0 bis 2(a1)+1-b1 steht b1+c1 größer oder gleich 1 ist
a2 für eine ganze Zahl von 0 bis 8 steht
b2 für eine ganze Zahl von 0 bis 2(a2)+1-c2 steht
c2 für eine ganze Zahl von 0 bis 2(a2)+1-b2 steht b2+c2 größer oder gleich 1 ist.

## Revendications

1. Procédé de production d'un composé métallocène de groupe 8 (VIII) représenté par la formule générale CpMCp', comprenant les étapes de :
a) réaction d'un composé de sel métallique (MXₙ), d'un composé Cp et d'un segment de liaison (L) pour former un composé intermédiaire, dans lequel MXₙ est un halogénure métallique anhydre ou hydraté ou un nitrate métallique et L est une phosphine ou un triester de phosphine ; et
b) réaction du composé intermédiaire avec un composé Cp' pour produire le composé métallocène, dans lequel,
M est électionné dans le groupe constitué de Ru, Os et Fe ;
Cp est différent de Cp', Cp et Cp' sont des fractions coordonnées par η^{m} et sont toutes deux substituées ou l'une ou les deux de Cp et Cp' inclue(nt) au moins un substituant qui est sélectionné dans le groupe constitué de :
A ;
Cₐ₁H_{b1}A_{c1} ;
Cₐ₂H_{b2}A_{c2}(C=O)Cₐ₁H_{b1}A_{c1} ;
Cₐ₂H_{b2}A_{c2}OCₐ₁H_{b1}A_{c1} ; Cₐ₂H_{b2}A_{c2}(C=O)OCₐ₁H_{b1}A_{c1} ; et
Cₐ₂H_{b2}A_{c2}O(C=O)Cₐ₁H_{b1}A_{c1} ;
où
A est F, Cl, Br, I ou NO₂ ;
a1 est un nombre entier de 1 à 8 ;
b1 est un nombre entier de 0 à 2(a1) + 1 - c1 ;
c1 est un nombre entier de 0 à 2(a1) + 1 - b1 ;
b1 + c1 est au moins 1 ;
a2 est un nombre entier de 0 à 8 ;
b2 est un nombre entier de 0 à 2(a2) + 1 - c2 ;
c2 est un nombre entier de 0 à 2(a2) + 1 - b2 ; et
m est le nombre d'atomes de carbone dans les fractions cycliques qui sont censés être liés à l'atome de métal.

2. Procédé selon la revendication 1, incluant en outre l'étape d'isolement du composé intermédiaire.

3. Procédé selon la revendication 1, dans lequel le composé Cp est un cyclopentadiène substitué ou non substitué et le composé Cp' est un sel de cyclopentadiénide.

4. Procédé selon la revendication 1, dans lequel l'une ou les deux de l'étape a) ou de l'étape b) est/sont réalisée(s) dans un milieu de solvant.

5. Procédé selon la revendication 4, dans lequel l'une ou les deux de l'étape a) ou de l'étape b) est/sont réalisée(s) à la température d'ébullition du mélange réactionnel.

6. Procédé selon la revendication 1, dans lequel l'une ou les deux de Cp ou Cp' inclue (nt) au moins un substituant supplémentaire sélectionné dans le groupe constitué de :
A
Cₐ₁H_{b1}A_{c1} ,
Cₐ₂H_{b2}A_{c2}(C=O)Cₐ₁H_{b1}A_{c1},
Cₐ₂H_{b2}A_{c2}OCₐ₁H_{b1}A_{c1},
Cₐ₂H_{b2}A_{c2}(C=O)OCₐ₁H_{b1}A_{c1}, ou
Cₐ₂H_{b2}A_{c2}O(C=O)Cₐ₁H_{b1}A_{c1}
où
A est F, Cl, Br, I ou NO₂ ;
a1 est un nombre entier de 0 à 8
b1 est un nombre entier de 0 à 2(a1) + 1 - c1
c1 est un nombre entier de 0 à 2(a1) + 1 - b1
b1 + c1 est supérieur ou égal à 1
a2 est un nombre entier de 0 à 8
b2 est un nombre entier de 0 à 2(a2) + 1 - c2
c2 est un nombre entier de 0 à 2(a2) + 1 - b2
b2 + c2 est supérieur ou égal à 1.
